# EUROPÄISCHE PATENTSCHRIFT

(11) **EP 3 243 246 B1**
(45) Veröffentlichungstag und Bekanntmachung des Hinweises auf die Patenterteilung: **29.04.2020**
(21) Anmeldenummer: 15817113.2
(22) Anmeldetag: 10.12.2015
(51) Int. Cl.: H01R 43/16, H01R 4/62, H01R 43/02, H01R 13/04, H01R 4/10, H01R 12/58, H01R 4/60

(54) **ELEKTRISCHES FUNKTIONSBAUTEIL MIT KONTAKTSTIFT UND VERFAHREN ZUR HERSTELLUNG EINES ELEKTRISCHEN FUNKTIONSBAUTEILS**
ELECTRICAL FUNCTIONAL COMPONENT HAVING A CONTACT PIN, AND METHOD FOR PRODUCING AN ELECTRICAL FUNCTIONAL COMPONENT
COMPOSANT FONCTIONNEL ÉLECTRIQUE À BROCHE DE CONTACT ET PROCÉDÉ DE FABRICATION D'UN COMPOSANT FONCTIONNEL ÉLECTRIQUE

(30) Priorität: 08.01.2015 DE 102015100149
(43) Veröffentlichungstag der Anmeldung: 15.11.2017
(73) Patentinhaber: Huber, Raimund, 6600 Lechaschau (AT)
(72) Erfinder: Huber, Raimund, 6600 Lechaschau (AT)
(74) Vertreter: advotec.
(86) Internationale Anmeldenummer: PCT/EP2015/079246
(87) Internationale Veröffentlichungsnummer: WO 2016/110369

(56) Entgegenhaltungen:
- EP-A1- 2 581 966
- US-A- 3 718 750

## Beschreibung

Die Erfindung betrifft ein elektrisches Funktionsbauteil mit zumindest einer Leiterbahn, an der ein Kontaktstift elektrisch leitend angebracht ist, nach dem Oberbegriff des Anspruchs 1. Weiter betrifft die Erfindung ein Verfahren zur Herstellung eines elektrischen Funktionsbauteils.

Gattungsgemäße elektrische Funktionsbauteile sind dadurch charakterisiert, dass am Funktionsbauteil zumindest eine elektrische leitende Leiterbahn vorgesehen ist. An dieser Leiterbahn ist dabei zumindest ein Kontaktstift angebracht. Der Kontaktstift hat dabei die Aufgabe, die Leiterbahn des Funktionsbauteils bevorzugt in lösbarer Weise mit einem funktionskomplementär ausgebildeten Kontaktelement zu kontaktieren. Bei dem funktionskomplementären Kontaktelement kann es sich beispielsweise um Steckelemente in einem Stecker oder einer Fassung handeln. In diesen Fällen ist das elektrische Funktionsbauteil selbst beispielsweise in der Art eines Steckers oder Leuchtmittels ausgebildet. Auch sind gattungsgemäße elektrische Funktionsbauteile bekannt, die in der Art von Leiterplatten ausgebildet sind. An diesen Leiterplatten dienen die Kontaktstifte der Kontaktierung der Leiterplatte, beispielsweise an Steckern oder Steckerleisten.

Um die elektrische Funktion des Funktionsbauteils zu gewährleisten, ist es gattungsgemäß erforderlich, dass zwischen Leiterbahn und Kontaktstift eine Kontaktzone vorgesehen ist, die die Leiterbahn und den Kontaktstift elektrisch leitend miteinander verbindet. Aufgrund der unterschiedlichen Funktionen von Kontaktstift und Leiterbahn ist es also mit anderen Worten erforderlich, dass diese beiden Bauteile getrennt voneinander gefertigt werden und anschließend in einem Fügeprozess elektrisch leitend und mechanisch belastbar miteinander verbunden werden. Da jede Kontaktstelle einen zusätzlichen elektrischen Widerstand erzeugt, der maßgeblich durch die Einschnürung der stromführenden Flächen in den Mikrokontakten verursacht ist, ist ein sehr guter elektrischer Kontakt zwischen den Kontaktstiften und Leiterbahnen unbedingt erforderlich, um Verlustleistungen zu vermeiden. Außerdem stellt die Kontaktzone zwischen Leiterbahn und Kontaktstift eine potenzielle Fehlerquelle für die Funktion des Funktionsbauteils dar, wenn die Kontaktqualität der Kontaktzone ein bestimmtes Maß unterschreitet.

Neben der Kontaktart ist die wahre metallische Kontaktfläche für die Kontaktqualität von maßgeblicher Bedeutung. Hierbei muss zwischen der Flächenüberdeckung, das heißt der scheinbaren Kontaktfläche zwischen Leiterbahn und Kontaktstift einerseits, und der tatsächlich stromtragenden, wahren metallischen Kontaktfläche unterschieden werden, denn die tatsächlich elektrisch tragende, wahre Kontaktfläche ist bei gleichen geometrischen Verhältnissen wesentlich kleiner. Dies liegt daran, dass auch scheinbar ebene Metalloberflächen sich aufgrund ihrer Oberflächentopographie beziehungsweise Rauheit nicht vollflächig berühren, sondern nur in verhältnismäßig kleinen Bereichen. Je weiter die beiden Kontaktflächen gegeneinander gedrückt werden, umso stärker nähert sich die wahre, elektrisch tragende Kontaktfläche dem Maß der scheinbaren Kontaktfläche an, was durch entsprechende Verformungen der Oberflächenspitzen erreicht wird.

Insbesondere in der Elektroenergietechnik ist es außerdem bekannt, dass Kontaktflächen über die Zeit altern und dabei der elektrische Widerstand über die Zeit zunimmt. Durch die altersbedingte Widerstandserhöhung können die Kontaktzonen sogar gänzlich zerstört werden. Dieser Mechanismus wird durch unterschiedliche, zeitgleich in den Kontaktzonen ablaufende Alterungsmechanismen (chemische Reaktionen, Elektromigration, Interdiffusion, Reibverschleiß und Kraftabbau) beeinflusst. Abhängig vom Belastungsstrom und den Umgebungsbedingungen kann einer oder können mehrere dieser Mechanismen die Alterung der Kontaktzone beschleunigen. Insbesondere bei thermisch hoch beanspruchten elektrischen Kontakten können aufgrund hoher Betriebstemperaturen der Kraftabbau und die chemischen Reaktionen durch Oxidation und Relaxation die Alterung entscheiden beschleunigen. Die Andruckkraft zwischen den Kontaktflächen kann aufgrund von dynamischen Erholungsprozessen, Kriechen oder Änderungen der mechanischen Eigenschaften des Leitermaterials innerhalb weniger Wochen stark abnehmen. Damit kann sich der Kontaktwiderstand bei geringen Verbindungskräften bezogen auf die Anfangswerte nach der Montage der Verbindung stark erhöhen und dadurch trotz Prüfung der Bauteile Funktionsfehler verursachen.

Zur Herstellung der Kontaktzone zwischen Leiterbahn und Kontaktstift sind aus dem Stand der Technik verschiedene Fügetechniken bekannt, die zugleich für einen ausreichenden elektrischen Kontakt zwischen Leiterbahn und Kontaktstift sorgen und die mechanische Befestigung des Kontaktstifts an der Leiterbahn realisieren. Die am häufigsten eingesetzten Verbindungstechniken zur Herstellung einer Kontaktzone zwischen Leiterbahn und Kontaktstift stellen das Schrauben, das Schweißen und das Nieten dar. Weniger häufig wird auch eine Lötverbindung eingesetzt.

Bei einer Schraubverbindung erfolgt der Stromschluss nur sekundär und in relativ kleinem Maß über das verwendete schraubbare Verbindungselement. Primär erfolgt der Stromschluss dagegen über die durch die Schraubverbindung erzeugten Kontaktflächen, in denen das Material der Leiterbahn und das Material des Kontaktstifts durch Andruck des Schraubelements gegeneinander gedrückt werden. Für die Kontaktqualität spielen hierbei insbesondere die Rauheit der Bauteiloberflächen und die vorhandenen Oxidationsschichten an den Kontaktflächen eine Rolle. Die Kontaktqualität solcher Schraubverbindungen an gattungsgemäßen elektrischen Funktionsbauteilen ist deshalb relativ gering und weist eine hohe Streuung auf. Nachteilig an derartigen Schraubverbindungen ist es außerdem, dass relativ viele Einzelteile vorgesehen werden müssen, deren Montage aufwendig ist. Bei zyklischen mechanischen Belastungen ist außerdem ein nachträgliches Serviceintervall notwenig, um den notwendigen Andruck zwischen den Kontaktflächen zuverlässig aufrechtzuerhalten.

Bei Einsatz von Schweißverfahren zur Kontaktierung zwischen Leiterbahn und Kontaktstift wird aufgrund des Stoffschlusses ein sehr geringer Verbindungswiderstand erreicht. Allerdings ist das Einsatzspektrum solcher Schweißverfahren zum Fügen des Kontaktstifts an der Leiterbahn relativ gering, da beschichtete und thermisch empfindliche Bauteile nicht oder nur sehr schwer geschweißt werden können. Insbesondere beim Fügen von thermisch empfindlichen Bauteilen, beispielsweise elektronischen Bauteilen, oder bei Baugruppen mit vormontierten Kunststoffteilen ist der Wärmeeintrag durch das Schweißen von entscheidendem Nachteil. Auch können Oberflächenbeschichtungen durch die Schweißung nachteilig beeinflusst werden. Weiterhin können auch die Bauteilauslegung und die daraus resultierende Bauteilgeometrie den Einsatz von Schweißen als Fügetechnik verhindern. Bei filigranen Bauteilen, beispielsweise sehr feinen Leiterbahnen, wird durch den Wärmeeintrag des Schweißens außerdem ein Wärmeverzug verursacht, der vielfach auch durch nachträgliches Richten der Bauteile nicht mehr korrigiert werden kann.

Bei der Verwendung von Nietverfahren zur Kontaktierung des Kontaktstifts mit der Leiterbahn können beispielsweise Kontaktstifte eingesetzt werden, an deren Schaft eine Kontaktniete angeformt ist. Diese Kontaktniete weist dabei einen Bund zur Abstützung im Randbereich einer Ausnehmung in der Leiterbahn auf. Außerdem ist die Kontaktniete mit einem Nietkopf ausgestattet, der auf der gegenüberliegenden Seite der Ausnehmung in der Leiterbahn umgelegt wird und dadurch einen Kraftschluss zwischen Kontaktstift und Leiterbahn realisiert. Dieser Kontaktschluss bewirkt eine axial gerichtete Andruckkraft zwischen der Stirnfläche des Bundes und der inneren Stirnfläche des Nietkopfes einerseits und den gegenüberliegenden Oberflächenbereichen der Leiterbahn andererseits. Eine radial wirkende Andruckkraft an der zylinderförmigen Umfangsfläche der Kontaktniete ist dagegen nicht oder nur in sehr geringem Maße vorhanden. Da keine radial wirkenden Kontaktkräfte in signifikantem Maße erzeugt werden können, ist die Kontaktqualität bei solchen Nietverbindungen relativ gering. Außerdem ist die Herstellung solcher Kontaktnieten am Kontaktstift aufwendig, da der Kontaktschaft, der Bund und der Nietkopfschaft regelmäßig nur durch spanende Fertigungsverfahren, insbesondere durch Drehen von Teilen, hergestellt werden können. Ein signifikanter Nachteil von Nietverbindungen ist ihre hohe Temperaturempfindlichkeit, da sich Nietverbindungen ab einer Umgebungstemperatur von circa 150 °C aufgrund der Materialrelaxation und dem damit verbundenen Kraftabbau lockern und die elektrische Kontaktqualität damit stark abfällt. Auch wird durch die Lockerung der Nietverbindung eine Spaltkorrosion begünstigt, was wiederum zum Ausfall des elektrischen Funktionsbauteils führen kann.

Zur Herstellung des elektrischen Kontakts zwischen Kontaktstift und Leiterbahn können diese auch miteinander verlötet werden. Solche Lötverfahren haben aber den Nachteil, dass eine relativ aufwendige Bearbeitung notwendig ist. Außerdem führt die Zuführung des Lotwerkstoffes häufig zu chemischen Reaktionen der Kontaktpartner, die die Kontaktstelle altern lassen.

Die US 3 718 750 A beschreibt einen Kontaktstift zur Durchkontaktierung zweier Leiterplatten. Der Kontaktstift weist dabei an seinem Umfang eine Riffelung auf. Bei der Montage des Kontaktstifts wird dieser durch entsprechende Ausnehmungen in den Leiterplatten durchgeschoben, wobei die Leiterbahnen der Leiterplatte jeweils zwei hülsenförmige Endstücke aufweisen, die in der Ausnehmung angeordnet sind. Durch das Einpressen des Kontaktstifts bildet sich dabei eine kaltgeschweißte Kontaktzone aus.

Ausgehend von diesem Stand der Technik ist es Aufgabe der vorliegenden Erfindung, ein neues elektrisches Funktionsbauteil mit einer Kontaktzone zwischen einer Leiterbahn und einem Kontaktstift vorzuschlagen, mit dem die oben beschriebenen Nachteile der gattungsgemäßen Funktionsbauteile vermieden werden. Außerdem ist es Aufgabe der vorliegenden Erfindung, ein neues Verfahren zur Herstellung solcher Funktionsbauteile vorzuschlagen.

Diese Aufgaben werden durch ein Funktionsbauteil beziehungsweise ein Verfahren nach der Lehre der beiden unabhängigen Hauptansprüche gelöst. Vorteilhafte Ausführungsformen der Erfindung sind Gegenstand der Unteransprüche.

Das erfindungsgemäße Funktionsbauteil, wobei die elektrisch leitende Kontaktzone zwischen Leiterbahn und Kontaktstift in der Art einer ringförmigen, kaltpressgeschweißten Übergangszone ausgebildet ist, ist dadurch charakterisiert, dass die den Kontaktstift aufnehmende Ausnehmung einen konusabschnittsförmigen Querschnitt aufweist, wobei sich die Ausnehmung in Fügerichtung des Kontaktstifts verengt. Durch Einsatz eines geeigneten Fertigungsverfahrens, insbesondere des nachfolgend noch zu beschreibenden erfindungsgemäßen Verfahrens, werden/wird beim Fügen des Kontaktstifts an der Leiterbahn das Oberflächenmaterial der Leiterbahn und/oder das Oberflächenmaterial des Kontaktstifts in der Übergangszone kalt umgeformt, sodass sich dort in den Randschichten des Materials der Leiterbahn beziehungsweise des Materials des Kontaktstifts eine Kaltumformzone ausbildet. Der Fügedruck ist dabei so hoch zu wählen, dass an oder in zumindest einer Kaltumformzone zumindest eine kaltgeschweißte Schweißzone entsteht, in der der Kontaktstift und die Leiterbahn elektrisch leitend stoffschlüssig miteinander verbunden sind. Da die Kontaktzone ringförmig ausgebildet ist, kann die Ausbildung der Kaltumformzone und der Schweißzone in einfacher Weise dadurch erreicht werden, dass der Außenumfang des Kontaktstifts und der Innenumfang der Ausnehmung beziehungsweise Vertiefung eine materialmäßige Überdeckung aufweist. Diese Überdeckung sorgt beim Einpressen des Kontaktstifts in die Ausnehmung beziehungsweise Vertiefung dafür, dass die beiden Bauteile in ihren oberflächlichen Materialschichten mit hohem Druck gegeneinander gedrückt und aneinander vorbei bewegt werden. Die dabei auftretenden Verformungen im Kristallgitter der beteiligten Fügepartner sorgen für eine zumindest bereichsweise vorhandene stoffschlüssige Verbindung.

Der Toleranzausgleich wird im Hinblick auf die Materialüberdeckung zwischen Kontaktstift und Leiterbahn dadurch vereinfacht, dass der Kontaktstift an zumindest einem Ende eine Querschnittsverengung, nämlich eine konusabschnittsförmigen Querschnitt, aufweist. Durch den enger werdenden Querschnitt des Kontaktstifts in Einpressrichtung kann der Kontaktstift außerdem sehr leicht in der Ausnehmung beziehungsweise der Vertiefung angelegt und zentriert werden. Mit zunehmender Einpresstiefe ergibt sich eine so hohe Materialüberdeckung, dass dann durch entsprechende Kaltumformungen der erfindungsgemäße Effekt der Bildung einer kaltpressgeschweißten Übergangszone ausgebildet wird.

Ob an beiden Fügepartnern jeweils Kaltumformzonen vorhanden sind und wie groß diese beiden Kaltumformzonen relativ zueinander ausfallen, ist insbesondere abhängig vom Kaltumformwiderstand der entsprechenden Materialien beziehungsweise Oberflächenbeschichtungen. Um eine hohe Kontaktqualität zu erreichen, ist es dabei anzustreben, dass beide Fügepartner in ihren oberflächlichen Materialschichten eine Kaltumformzone aufweisen, wobei diese Kaltumformzonen die dazwischen angeordnete Schweißzone schichtförmig umschließen.

Das notwendige Maß der Materialüberdeckung zwischen den beiden Fügepartnern kann durch einfache Versuche unter Anfertigung von Schliffbildern der Kontaktzone bestimmt werden. Die Materialüberdeckung darf dabei nur so groß sein, dass eine makroskopische Verformung der beiden Fügepartner durch den Fügeprozess ausgeschlossen ist. Umgekehrt muss die Materialüberdeckung so groß sein, dass sich durch das Einpressen des Kontaktstifts in die Ausnehmung beziehungsweise Vertiefung zumindest bereichsweise eine kaltgeschweißte Schweißzone mit stoffschlüssiger Verbindung zwischen den beiden Fügepartnern ausbildet. Durch Prüfung der Einpresskraft in der laufenden Fertigung bzw. Anfertigung von Schliffbildern und Prüfung der Auszugskraft in Form von Stichprobenprüfung kann dies in einfacher Weise kontrolliert werden.

Das erfindungsgemäße Funktionsbauteil hat gegenüber dem vorbekannten Stand der Technik den Vorteil, dass eine mechanisch hoch belastbare Verbindung zwischen den beiden Fügepartnern einerseits und eine elektrische Kontaktzone mit hoher elektrischer Leitungsqualität in einem Schritt hergestellt werden können. Ein makroskopischer Wärmeeintrag in das Material tritt dabei nicht auf, sodass unerwünschte Verzugseffekte ausgeschlossen sind. Außerdem können Fügepartner mit fast beliebigen Materialeigenschaften mechanisch und elektrisch leitend gleichzeitig miteinander gefügt werden. Die kaltgeschweißte Kontaktzone unterliegt dabei keiner Spaltkorrosion und ein Abfall der Leitungsqualität in der Kontaktzone auch über einen längeren Zeitraum ist nahezu ausgeschlossen.

In welcher konstruktiven Weise die Leiterbahn ausgebildet ist, ist grundsätzlich beliebig, solange die Leiterbahn eine ausreichende mechanische Stabilität aufweist, um den Kontaktstift in die Ausnehmung beziehungsweise die Vertiefung einzupressen. Beispielsweise kann es sich bei der Leiterbahn auch um ein massives metallisches Bauteil handeln, wie es beispielsweise zur Herstellung von Steckkontakten an Leuchtmitteln bekannt ist. Im Hinblick auf die Vermeidung eines hohen Wäremeeintrages und der dadurch verursachten unerwünschten Verzugseffekte weist die Erfindung besonders große Vorteile auf, wenn die Leiterbahn in der Art eines Leiterblechs, insbesondere in der Art eines Stanzgitters, ausgebildet ist. An solchen Leiterblechen können hochfiligrane Leiterbahnen vorgesehen sein, die insbesondere durch Ausstanzen preisgünstig herstellbar sind. Durch geeignete Presswerkzeuge mit einer Vielzahl von Aufnahmen für die Kontaktstifte ist es möglich, ein solches Leiterblech in einfacher und kostengünstiger Weise gleichzeitig mit einer Vielzahl von Kontaktstiften auszustatten. Die Kaltumformung unter Bildung der Kaltschweißzone führt dabei außerdem dazu, dass die Kontaktstifte mechanisch hochfest mit dem Leiterblech verbunden werden und somit hohe maximale Ausziehkräfte erreichen.

Die mechanische Festigkeit der Verbindung zwischen dem Kontaktstift und der Leiterbahn und die elektrische Leitungsqualität zwischen Kontaktstift und Leiterbahn wurden maßgeblich davon beeinflusst, wie groß die ringförmige, kaltpressgeschweißte Übergangszone ist. Der Durchmesser der Übergangszone ist dabei vielfach bauartbedingt vorgegeben, da beispielsweise die Breite von Leiterbahnen in Leiterblechen nicht beliebig vergrößerbar ist. Außerdem ist auch der Durchmesser der Stecckontakte vielfach vorgegeben. Insbesondere bei der Verwendung besonders dünner Leiterbahnen ist es deshalb von Vorteil, wenn im Bereich der Kontaktzone ein ringförmiger Überstand an der Leiterbahn vorgesehen ist, der eine Materialverdickung in der Leiterbahn bildet. Ist die Ausnehmung beziehungsweise Vertiefung im Bereich dieses Überstandes angeordnet, so kann dadurch die Höhe der ringförmigen, kaltpressgeschweißten Übergangszone vergrößert werden. Insbesondere ist auch eine Höhe der Übergangszone möglich, die größer als die Dicke der Leiterbahn selbst ist.

Um beim Einpressen der Kontaktstifte in die Ausnehmung einer Leiterbahn einen sicheren Sitz mit hoher Leitungsqualität erreichen zu können, ohne überhohe Toleranzen im Hinblick auf die Durchmesserüberdeckung einhalten zu müssen, ist es besonders vorteilhaft, wenn der Kontaktstift die Leiterbahn in der Ausnehmung vollständig durchgreift und mit beiden Enden über die Leiterbahn zumindest ein Stück weit übersteht. Durch den beidseitigen Überstand des Kontaktstifts über die Leiterbahn ist es beim Einpressen möglich, dass zum Ausgleich von Toleranzen, insbesondere zum Ausgleich von Durchmessertoleranzen, die Durchstecktiefe des Kontaktstifts variiert wird. Insbesondere kann ein derartiger Toleranzausgleich dadurch vereinfacht werden, dass sich der Kontaktstift in Fügerichtung verjüngt beziehungsweise die Ausnehmung sich in Fügerichtung verengt (dazu siehe die Beschreibung weiter unten). Durch die Aufweitung des Kontaktstifts mit zunehmender Einpresstiefe beziehungsweise durch die Verjüngung der Ausnehmung mit zunehmender Einpresstiefe wird erreicht, dass die Materialüberdeckung mit zunehmender Einstecktiefe immer größer wird.

Die erfindungsgemäße Kontaktierung durch Einpressen eines Kontaktstifts unter Bildung einer kaltpressgeschweißten Übergangszone ist insbesondere auch dann von Vorteil, wenn zwei Leiterbahnen durchkontaktiert werden sollen. Dazu kann dann in beiden Leiterbahnen jeweils eine Ausnehmung vorgesehen werden. Diese Ausnehmungen werden dann übereinander fluchtend angeordnet und der Kontaktstift unter Bildung jeweils einer kaltpressgeschweißten Übergangszone in jeder Ausnehmung durchgesteckt.

Die Querschnittsänderung des Kontaktstifts, die zur Bildung einer erwünschten Querschnittsverengung erforderlich ist, kann selbstverständlich durch beliebige Fertigungsverfahren, beispielsweise durch spanabhebende Fertigung der Kontaktstifte, hergestellt werden. Diese Art der Herstellung ist allerdings relativ kostenaufwendig, da es sich bei den Kontaktstiften um Massenteile handelt. Bevorzugt ist es deshalb, wenn der Kontaktstift an zumindest einer Stirnseite eine Rissfläche aufweist und hinter der Stirnseite zumindest über einen kurzen Abschnitt hinweg eine Einschnürung aufweist. Solche Kontaktstifte können durch Anwendung von Reißverfahren an Endlosdrähten sehr kostengünstig hergestellt werden. Dabei kann der beispielsweise stark erwärmte Draht in der Reißvorrichtung in Richtung seiner Längsausstreckung so weit gezogen werden, dass er sich jeweils in einem definierten Abstand einschnürt und quer zur Einschnürung unter Bildung der Stirnseite des Kontaktstifts abreißt. Derartige Kontaktstifte können sehr kostengünstig hergestellt werden und weisen eine hohe Maßgenauigkeit im Hinblick auf den Außendurchmesser auf.

Weiterhin ist es besonders vorteilhaft, wenn der Querschnitt des Kontaktstifts bezüglich seiner Mitte spiegelsymmetrisch ausgebildet ist. Durch die spiegelsymmetrische Gestaltung des Kontaktstifts kann erreicht werden, dass der Kontaktstift wahlweise mit dem einen oder dem anderen Ende in die Ausnehmung beziehungsweise Vertiefung eingepresst werden kann. Bei der Zuführung der Kontaktstifte an die Fügevorrichtung ist es von großem Vorteil, dass die Kontaktstifte während der Zuführung nicht in einer Vorzugsrichtung ausgerichtet werden müssen. Stattdessen können für die Zuführung einfache Rütteltöpfe zum Einsatz kommen, die die Kontaktstifte in ihrer Längsrichtung ausrichten, ohne dass dabei Rücksicht auf eine Vorzugsrichtung des Kontaktstifts genommen werden muss.

Im Hinblick auf die Langzeitstabilität der kaltpressgeschweißten Übergangszone ist es besonders vorteilhaft, wenn die Kontaktzone, in der der Kontaktstift eingepresst wird, an einem Ende der Leiterbahn angeordnet ist. An diesem Ende der Leiterbahn kann dann ein ringabschnittsförmiger Kontaktbereich vorgesehen werden, der die ringförmige, kaltpressgeschweißte Übergangszone allseitig umgreift. Beim Einpressen des Kontaktstifts in diesen ringabschnittsförmigen Kontaktbereich wird das Material der Leiterbahn dann aufgrund der Materialüberdeckung radial aufgeweitet und dabei nicht nur in der Kontaktzone plastisch umgeformt, sondern insgesamt elastisch aufgeweitet. Die daraus resultierenden elastischen Rückstellkräfte bewirken, dass der ringabschnittsförmige Kontaktabschnitt elastisch nach innen gepresst wird und die kaltpressgeschweißte Übergangszone auch über lange Zeiträume spaltfrei zusammenhält.

Wie bereits erläutert, ist die Einhaltung eines exakt definierten Materialüberstandes zwischen dem Außenumfang des Kontaktstifts und dem Innenumfang der Ausnehmung beziehungsweise Vertiefung für die Ausbildung der erfindungsgemäßen kaltpressgeschweißten Übergangszone von großer Bedeutung. Um den Materialüberstand prozesssicher in hohen Stückzahlen einhalten zu können, ist es deshalb besonders vorteilhaft, wenn der Kontaktstift zumindest bereichsweise einen kalibrierten Außenumfang und/oder die Ausnehmung beziehungsweise die Vertiefung einen zumindest bereichsweise kalibrierten Innenumfang aufweisen/aufweist. Durch die Kalibrierung der Umfänge kann eine hohe Maßhaltigkeit gewährleistet werden, die das Einhalten feiner Toleranzen im Bereich des Materialüberstandes ermöglichen.

Soweit die verwendeten Materialien zur Herstellung des Kontaktstifts beziehungsweise der Leiterbahn es nur bedingt zulassen, dass eine kaltpressgeschweißte Übergangszone ausgebildet wird, können die Leiterbahn und/oder der Kontaktstift eine metallische Beschichtung aufweisen. Der Umformwiderstand des Beschichtungsmaterials ist dabei geringer zu wählen als der Umformwiderstand des darunter liegenden beschichteten Materials, um auf diese Weise die Ausbildung einer kaltpressgeschweißten Übergangszone zu vereinfachen, denn Materialien mit geringerem Umformwiderstand, beispielsweise Gold oder Silber, ermöglichen es, mit hoher Fügequalität eine kaltpressgeschweißte Übergangszone auszubilden.

Die Querschnittsform des Kontaktstifts beziehungsweise die Querschnittsform der Ausnehmung beziehungsweise der Vertiefung und daraus resultierend die Querschnittsform der ringförmigen, kaltpressgeschweißten Übergangszone ist grundsätzlich beliebig. In den einfachsten Bauformen ist es vorgesehen, dass kreisrunde Kontaktstifte in kreisrunde Ausnehmungen beziehungsweise Vertiefungen eingepresst werden, sodass sich eine zylinderförmige Übergangszone ausbildet. Alternativ dazu kann der Kontaktstift aber auch jede beliebige prismatische Gestalt aufweisen, beispielsweise quadratisch oder vieleckig sein. Der Querschnitt der Ausnehmung beziehungsweise der Vertiefung sollte dabei einen entsprechenden prismatischen Aufbau aufweisen. Im Ergebnis kann damit dann eine kaltpressgeschweißte Übergangszone mit prismatischer Gestalt hergestellt werden.

An welcher Art von elektrischem Funktionsbauteil die erfindungsgemäße ringförmige, kaltpressgeschweißte Übergangszone vorgesehen ist, ist grundsätzlich beliebig. Besonders vorteilhaft ist diese Art der Anbringung von Kontaktstiften an Leiterbahnen durch ein kaltumformendes Fügeverfahren bei Leiterplatten, Steckern oder Leuchtmitteln.

Zur Herstellung des erfindungsgemäßen Funktionsbauteils kann ein Verfahren mit folgenden Verfahrensschritten eingesetzt werden:
a) Zunächst wird in einer Leiterbahn eine Ausnehmung mit einem konusabschnittsförmigen Querschnitt hergestellt. Dies kann beispielsweise bei Verwendung einer Leiterplatte aus Blech durch Einsatz eines Stanzwerkzeuges geschehen, mit dem das Leiterblech durchgestanzt wird.
b) Anschließend wird einer oder werden mehrere Kontaktstifte zugeführt, wobei der Außenumfang des Kontaktstifts zumindest abschnittsweise größer als der Innenumfang der konusabschnittsförmigen Ausnehmung ist. Das eine Ende des Kontaktstifts wird in die konusabschnittsförmige Ausnehmung eingeführt beziehungsweise angelegt.
c) Befinden sich Kontaktstift und Ausnehmung beziehungsweise Vertiefung in der richtigen Relativlage, wird durch Einsatz eines geeigneten Werkzeuges, beispielsweise eines Pressstempels mit Vertiefungen, in denen die Kontaktstifte gehalten sind, der Kontaktstift in die konusabschnittsförmige Ausnehmung eingepresst. Aufgrund der Materialüberdeckung zwischen Kontaktstift einerseits und der Ausnehmung der Leiterbahn andererseits bildet sich beim Einpressen eine ringförmige, kaltpressgeschweißte Übergangszone. Diese Übergangszone beinhaltet eine Schweißzone, in der Kontaktstift und Leiterbahn elektrisch leitend miteinander verbunden sind.

Zur Herstellung der Ausnehmung in einem Leiterblech kann ein Stanzwerkzeug eingesetzt werden, mit dem das Leiterblech durchgelocht wird.

Zur Herstellung eines ringförmigen Überstandes im Bereich der Ausnehmung eines Leiterblechs kann ein Dorn eingesetzt werden, mit dem das Material des Leiterblechs durchgezogen wird. Dadurch kann eine Höhe der Übergangszone erreicht werden, die größer ist als die Dicke des verwendeten Leiterblechs.

Um die Ausnehmung im Leiterblech auf einen eng tolerierten Durchmesser zu kalibrieren, kann ein Kalibrierdorn oder ein sonstiges Kalibrierwerkzeug in die Ausnehmung eingeführt und durchgesteckt werden.

Um zwei Leiterbahnen durchzukontaktieren, werden diese mit zueinander fluchtenden Ausnehmungen übereinander angeordnet und dann wird ein Kontaktstift durch beide Ausnehmungen gleichzeitig zumindest teilweise durchgreifend eingepresst.

Werden auf diese Weise mehrere Kontaktstifte gleichzeitig durch beide Leiterbahnen durchkontaktiert, so kann dadurch auch eine Befestigung der beiden Leiterbahnen relativ zueinander realisiert werden.

Besonders kostengünstig wird das erfindungsgemäße Verfahren, wenn zur Herstellung des Kontaktstifts ein endloses Drahtmaterial in Drahtabschnitte, insbesondere mit endseitigen Einschnürungen, gerissen wird.

Verschiedene Ausführungsformen der Erfindung sind in den Zeichnungen teilweise schematisch dargestellt und werden nachfolgend beispielhaft erläutert.

Es zeigen:
- **Fig. 1**: ein elektrisches Funktionsbauteil mit mehreren Leiterbahnen und Kontaktelementen in perspektivischer Ansicht;
- **Fig. 2**: eine Leiterbahn des Funktionsbauteils gemäß Fig. 1 vor der Anbringung eines Überstandes im Querschnitt und in seitlicher Ansicht;
- **Fig. 3**: die Leiterbahn gemäß Fig. 2 nach Anbringen eines Überstandes und vor Anbringen eines Kontaktstifts im Querschnitt und in seitlicher Ansicht;
- **Fig. 4**: die Leiterbahn gemäß Fig. 3 bei Anlegen eines Kontaktstifts vor dem Einpressen im Querschnitt und in seitlicher Ansicht;
- **Fig. 5**: die Leiterbahn mit dem Kontaktstift gemäß Fig. 4 nach dem Einpressen im Querschnitt und in seitlicher Ansicht;
- **Fig. 6**: zwei Leiterbahnen beim Anlegen eines gemeinsamen Kontaktstifts vor dem Einpressen im Querschnitt;
- **Fig. 7**: die Leiterbahnen mit dem Kontaktstift gemäß Fig. 6 nach dem Einpressen im Querschnitt;
- **Fig. 8**: die Kontaktzone zwischen der Leiterbahn und dem Kontaktstift gemäß Fig. 5 im vergrößerten Ausschnitt A;
- **Fig. 9**: eine Leiterbahn mit zylindrischer Ausnehmung und Überstand im Querschnitt;
- **Fig. 10**: die Leiterbahn gemäß Fig. 9 in Ansicht von oben;
- **Fig. 11**: eine zweite Leiterbahn mit konusabschnittsförmiger Ausnehmung im Querschnitt;
- **Fig. 12**: die Leiterbahn gemäß Fig. 11 in Ansicht von oben;
- **Fig. 13**: eine Leiterbahn mit zylindrischer Ausnehmung und einer Fase an einem der Endquerschnitte im Querschnitt;
- **Fig. 14**: die Leiterbahn gemäß Fig. 13 in Ansicht von oben;
- **Fig. 15**: eine weitere Leiterbahn mit zylindrischer Ausnehmung und einem Radius an einem Endquerschnitt im Querschnitt;
- **Fig. 16**: die Leiterbahn gemäß Fig. 15 im Querschnitt;
- **Fig. 17**: eine weitere Leiterbahn mit zylindrischer Ausnehmung und zwei Fasen an beiden Endquerschnitten im Querschnitt;
- **Fig. 18**: die Leiterbahn gemäß Fig. 17 in Ansicht von oben;
- **Fig. 19**: eine weitere Leiterbahn mit zylindrischer Ausnehmung und zwei Radien an beiden Endquerschnitten im Querschnitt;
- **Fig. 20**: die Leiterbahn gemäß Fig. 19 in Ansicht von oben;
- **Fig. 21**: eine Leiterbahn mit einer prismatischen, nämlich quadratförmigen, Ausnehmung in Ansicht von oben;
- **Fig. 22**: eine Leiterbahn mit einer prismatischen, nämlich rechteckförmigen, Ausnehmung und einer Fase an den Endquerschnitten in Ansicht von oben;
- **Fig. 23**: eine Leiterbahn mit prismatischer, nämlich rechteckförmiger, Ausnehmung mit einem Radius an den Endquerschnitten in Ansicht von oben; und
- **Fig. 24**: einer quadratischen Leiterbahn mit zylindrischer Ausnehmung und kreisabschnittsförmigen Entlastungsöffnungen in Ansicht von oben.

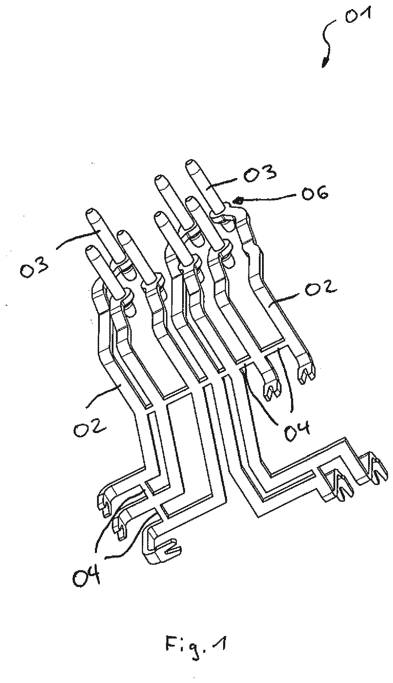

**Figur 1** zeigt ein elektrisches Funktionsbauteil 01 mit mehreren Leiterbahnen 02, an deren Enden jeweils Kontaktstifte 03 elektrisch leitend angebracht sind. Die Kontaktstifte 03 dienen dabei zur Anbringung eines in Fig. 1 nicht dargestellten Steckers am Funktionsbauteil 01.

Die Leiterbahnen 02 sind durch Ausstanzen eines Leiterblechs hergestellt, wobei aus Montagegründen zunächst noch diverse Verbindungsstege 04 verbleiben. Die Verbindungsstege 04 werden nach dem Umspritzen des Funktionsbauteils 01 mit Kunststoff entfernt, sodass alle Leiterbahnen 02 elektrisch voneinander isoliert sind.

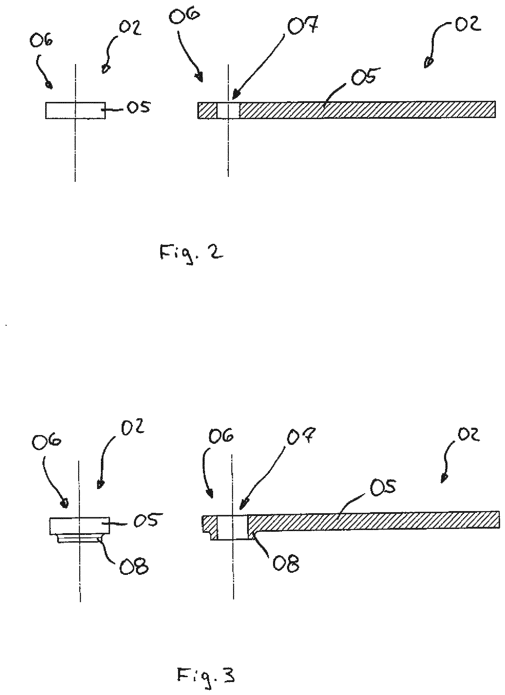

Zwischen den Leiterbahnen 02 und den Kontaktstiften 03 ist jeweils eine elektrisch leitende Kontaktzone vorhanden, sodass elektrischer Strom zwischen den Leiterbahnen 02 und den Kontaktstiften 03 im Wesentlichen widerstandsfrei übertragen werden kann. Die elektrische Kontaktzone zwischen den Leiterbahnen 02 und den Kontaktstiften 03 wird dabei durch Einpressen der Kontaktstifte 03 in zylindrische Ausnehmungen am Ende der Leiterbahnen 02 realisiert, wobei durch das Einpressen der Kontaktstifte 03 eine ringförmige, kaltpressgeschweißte Übergangszone zwischen den Leiterbahnen 02 und den Kontaktstiften 03 ausgebildet wird. Das Verfahren zur Herstellung der elektrisch leitenden Kontaktzone zwischen den Kontaktstiften 03 und den Leiterbahnen 02 soll nachfolgend anhand der Zeichnungen **Figur 2** bis **Figur 5** näher erläutert werden.

In **Figur 2** ist zunächst das Leiterblech 05, aus dem die Leiterbahnen 02 herausgestanzt werden, im Querschnitt dargestellt. Am Ende 06 der Leiterbahnen 02 wird mittels eines Stanzdorns eine Ausnehmung 07 mit zylindrischem Querschnitt angebracht.

**Figur 3** stellt die Leiterbahn 02 nach einem weiteren Fertigungsschritt dar. In diesem Fertigungsschritt wird mittels eines Dorns das Material des Leiterblechs 05 im Bereich der Ausnehmung 07 durchgezogen und dabei das Leiterblech 05 im Bereich der Ausnehmung 07 unter Bildung eines Überstandes 08 kaltverformt. Wie aus Fig. 3 ersichtlich, weist die Leiterbahn 02 damit im Bereich der Ausnehmung 07 eine Materialverdickung auf, deren Dicke größer ist als die Dicke des verwendeten Leiterblechs 05.

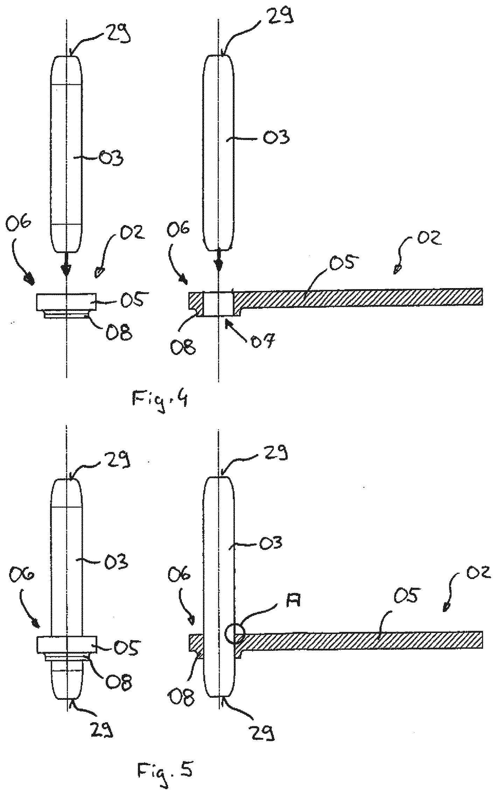

**Figur 4** zeigt die Leiterbahn 02 und den Kontaktstift 03 unmittelbar vor dem Einpressen in die Ausnehmung 07. Der Kontaktstift 03 ist durch Ablängen von Drahtabschnitten hergestellt, wobei das Ablängen durch Abreißen der Kontaktstifte erfolgt. An den Stirnseiten 29 ist deshalb jeweils eine Rissfläche gebildet, wobei die Rissfläche jeweils an eine Materialeinschnürung 09 grenzt, die durch das Abreißen des Endlosdrahtes gebildet wird. Der Außendurchmesser des Kontaktstifts 03 ist dabei geringfügig, beispielsweise um einige Zehntel Millimeter, größer als der Innendurchmesser der Ausnehmung 07. Durch die Einschnürung 09 kann der Kontaktstift 03 vor dem Einpressen problemlos in die Ausnehmung 07 eingeführt und zentriert werden.

**Figur 5** zeigt die Leiterbahn 02 und den Kontaktstift 03 nach dem Einpressen des Kontaktstifts 03 in die Ausnehmung 07; man erkennt, dass der Kontaktstift 03 mit beiden Enden über die Endquerschnitte der Ausnehmung 07 übersteht. Dies bedeutet mit anderen Worten, dass der Kontaktstift 03 beim Einpressen durch die Leiterbahn 02 durchgesteckt wird, um dadurch Maßtoleranzen im Bereich der Materialüberdeckung zwischen dem Innendurchmesser der Ausnehmung 07 und dem Außendurchmesser des Kontaktstifts 03 auszugleichen. Da der Kontaktstift 03 bezüglich seiner Mitte spiegelsymmetrisch ausgebildet ist und die beiden Enden die gleiche Gestalt aufweisen, kann der Kontaktstift 03 mit beiden Enden voraus zugeführt und eingepresst werden.

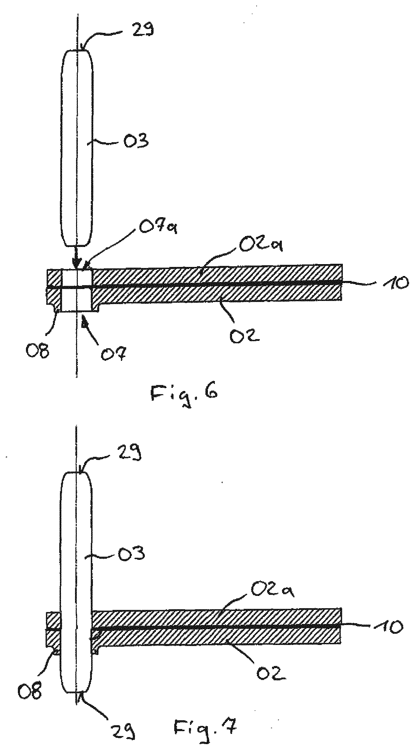

**Figur 6** und **Figur 7** zeigen schematisch ein Verfahren zur Durchkontaktierung zweier Leiterbahnen 02 und 02a durch Einpressen eines Kontaktstifts 03. Dabei werden die beiden Leiterbahnen 02 und 02a so übereinander angeordnet, dass die beiden Ausnehmungen 07 und 07a übereinander fluchten. Durch Einpressen des Kontaktstifts 03, wobei die beiden Enden 09 jeweils über die Leiterbahnen 02 und 02a überstehen, werden die Leiterbahnen miteinander kontaktiert. Zwischen den Leiterbahnen 02 und 02a kann dabei eine Isolatorschicht 10 vorgesehen werden.

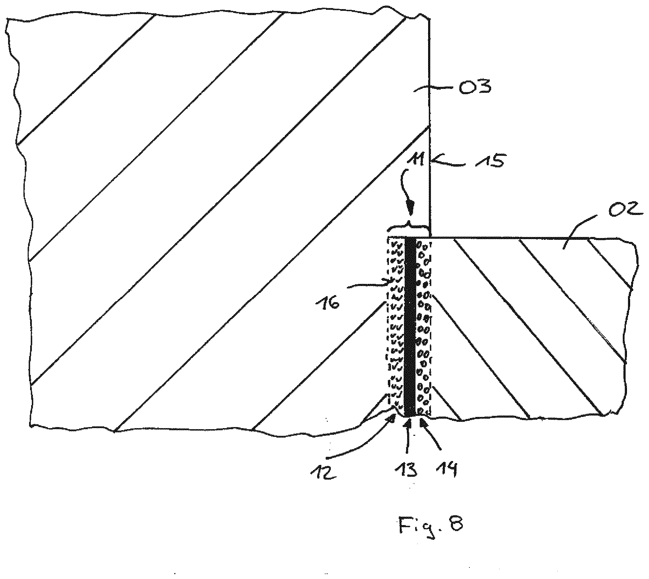

**Figur 8** zeigt den Kontaktstift 03 und die Leiterbahn 02 im vergrößerten Ausschnitt A gemäß Fig. 5. Zwischen Kontaktstift 03 und Leiterbahn 02 ist eine ringförmig verlaufende, kaltpressgeschweißte Übergangszone 11 gebildet, die in Fig. 8 zum leichteren Verständnis der Erfindung lediglich schematisiert und beispielhaft in vergrößertem Maßstab dargestellt ist. In der Übergangszone 11 sind eine ringförmig verlaufende Kaltumformzone 12, die aus dem Material des Kontaktstifts 03 besteht, eine ringförmig verlaufende Schweißzone 13, in der das Material des Kontaktstifts 03 und das Material der Leiterbahn 02 stoffschlüssig miteinander verschweißt sind, und eine ringförmig verlaufende Kaltumformzone 14 aus dem Material der Leiterbahn 02 hintereinander angeordnet. Die Kaltumformzonen 12 und 14 und die Schweißzone 13 entstehen beim Einpressen des Kontaktstifts 03 in die Ausnehmung 07 der Leiterbahn 02 aufgrund der Materialüberdeckung zwischen dem Außenumfang 15 des Kontaktstifts 03 und dem Innenumfang 16 der Ausnehmung 07. Die Materialüberdeckung ist dabei abhängig von der Materialwahl für den Kontaktstift 03 und die Leiterbahn 02 so zu wählen, dass sich nach dem Einpressen des Kontaktstifts 03 in die Ausnehmung 07 zumindest bereichsweise eine Schweißzone 13 ausbildet, in der der Kontaktstift 03 mit der Leiterbahn 02 stoffschlüssig kaltverschweißt ist. Dies kann durch Anfertigung von Schliffbildern in einfacher Weise kontrolliert werden. Die in Fig. 8 dargestellte Geometrie der Kaltumformzonen 12 und 14 und der Schweißzone 13 ist lediglich schematisch zu verstehen, da die tatsächlichen Verhältnisse sehr stark von den jeweils verwendeten Materialien abhängen.

Durch Kalibrierung des Außenumfangs 15 am Kontaktstift 03 beziehungsweise durch alternative beziehungsweise additive Kalibrierung des Innenumfangs 16 in der Ausnehmung 07 der Leiterbahn 02 kann eine sichere Prozesssteuerung bei der Ausbildung der Schweißzone 13 erreicht werden, die für eine hohe Kontaktqualität zwischen Kontaktstift 03 und Leiterbahn 02 sorgt. Durch Anbringung von Beschichtungen im Bereich des Außenumfangs 15 beziehungsweise des Innenumfangs 16 kann außerdem die Qualität des elektrischen Kontakts in der Schweißzone 13 erhöht werden.

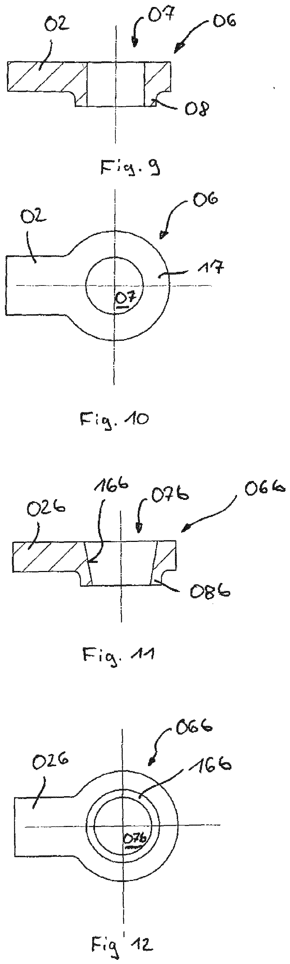

**Figur 9** zeigt das Ende 06 der Leiterbahn 02 mit der zylindrischen Ausnehmung 07 und dem Überstand 08 im vergrößerten Querschnitt. **Figur 10** zeigt das Ende 06 an der Leiterbahn 02 in Ansicht von oben. Man erkennt, dass das Material der Leiterbahn 02 die Ausnehmung 07 in einem ringabschnittsförmigen Kontaktbereich 17 umschließt. Beim Einpressen des Kontaktstifts 03 in die Ausnehmung 07 wird dieser ringabschnittsförmige Kontaktbereich am Innenumfang 16 nicht nur plastisch umgeformt, sondern in Radialrichtung auch elastisch aufgeweitet. Diese elastische Aufweitung bewirkt eine elastische Rückstellkraft, durch die der Innenumfang 16 nach dem Einpressen des Kontaktstifts 03 gegen den Außenumfang 15 gepresst und vorgespannt wird. Durch diese elastische Vorspannung des ringabschnittsförmigen Kontaktbereichs 17 können Kriech- und Alterungsvorgänge im Hinblick auf die elektrische Leitungsqualität ausgeglichen werden, da das Material der Leiterbahn 02 durch die elastische Vorspannung dauerhaft gegen das Material des Kontaktstifts 03 gepresst wird.

**Figur 11** zeigt eine Ausführungsform 02b einer Leiterbahn. Am Ende 06 der Leiterbahn 02b ist eine im Querschnitt konusabschnittsförmige Ausnehmung 07b vorgesehen, die wiederum auch einen Überstand 08b durchgreift. Durch die konusförmige Verengung des Querschnitts der Ausnehmung 07b kann bewirkt werden, dass Maßtoleranzen im Bereich der Materialüberdeckung zwischen dem Außenumfang 15 des Kontaktstifts 03 und dem Innenumfang 16b der Leiterbahn 02b problemlos ausgeglichen werden können. Der Öffnungswinkel der konusförmigen Ausnehmung 07b ist dabei in Fig. 11 übertrieben dargestellt. In den meisten Fällen reicht bereits ein Öffnungswinkel von wenigen Grad aus, um den notwendigen Toleranzausgleich zu gewährleisten.

**Figur 12** zeigt die Leiterbahn 02b in Ansicht von oben, wobei man die Querschnittsverengung der Ausnehmung 07b mit den unterschiedlichen Durchmessern an den beiden Endquerschnitten erkennt.

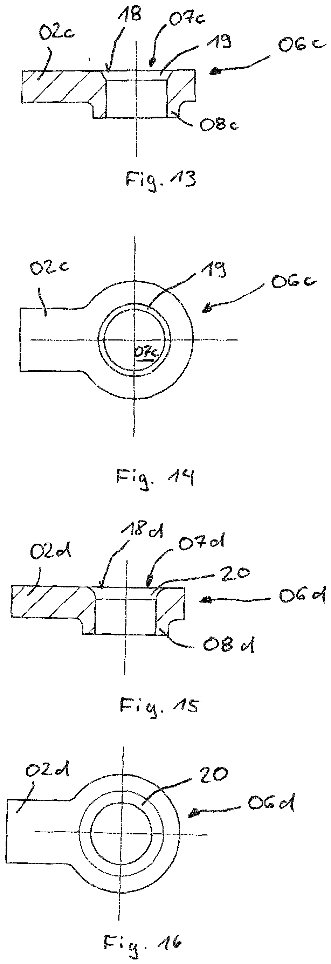

**Figur 13** zeigt ein weiteres Beispiel 02c einer Leiterbahn, an deren Enden 06c wiederum eine Ausnehmung 07c angebracht ist. Die Ausnehmung 07c durchgreift dabei auch den Überstand 08c. Am oberen Endquerschnitt 18 der Ausnehmung 07c ist eine konusförmige Fase 19 angebracht, um das Einstecken und Zentrieren des Kontaktstifts 03 vor dem Einpressen zu erleichtern.

**Figur 14** zeigt die Leiterbahn 02c mit der Fase 19 in Ansicht von oben.

**Figur 15** zeigt ein weiteres Beispiel 02d einer Leiterbahn, an deren zylindrischen Ausnehmungen 07d im Bereich des Endquerschnitts 18d ein Radius 20 angebracht ist, der wiederum das Einstecken und Zentrieren des Kontaktstifts 03 vor dem Einpressen erleichtert.

**Figur 16** zeigt die Leiterbahn 02d mit dem Radius 20 in Ansicht von oben.

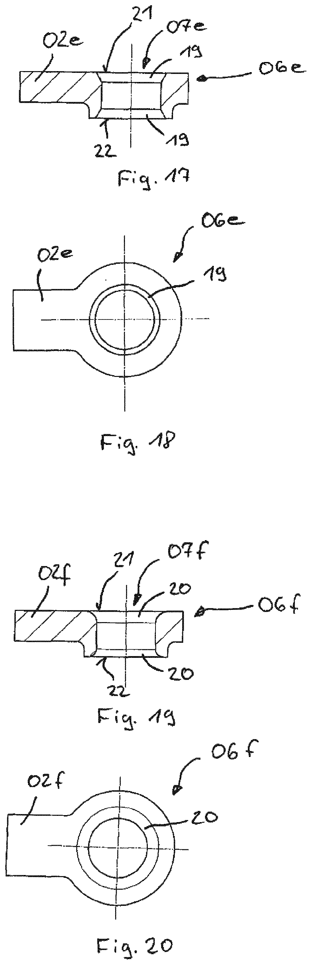

**Figur 17** zeigt ein weiteres Beispiel 02e einer Leiterbahn mit zylindrischer Ausnehmung 07e, die an den Endquerschnitten 21 und 22 jeweils Fasen 19 aufweist. Auf diese Weise kann der Kontaktstift 03 wahlweise von unten oder von oben in die Ausnehmung 07e eingepresst werden.

**Figur 18** zeigt die Leiterbahn 02e in Ansicht von oben.

**Figur 19** und **Figur 20** zeigen ein weiteres Beispiel 02f einer Leiterbahn, deren zylindrische Ausnehmung 07f an den Endquerschnitten 21 und 22 jeweils Radien 20 aufweist, sodass der Kontaktstift 03 wahlweise von oben oder von unten in die Leiterbahn eingepresst werden kann.

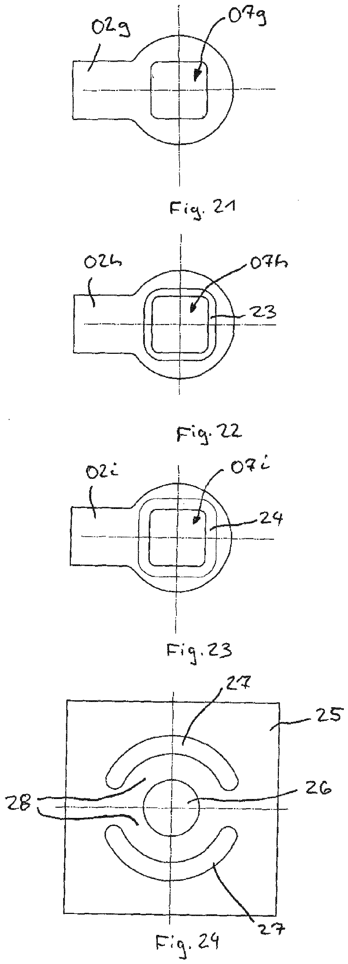

**Figur 21** zeigt ein weiteres Beispiel 02g einer Leiterbahn mit einer prismatischen Ausnehmung 07g. Die prismatische Ausnehmung 07g weist dabei einen im Wesentlichen quadratförmigen Querschnitt auf, dessen Ecken abgerundet sind. Der dabei zu verwendende Kontaktstift, der in die Leiterbahn 02g eingepresst wird, weist dabei einen formkomplementären Querschnitt auf, wobei wiederum eine geeignete Materialüberdeckung vorzusehen ist, um beim Einpressen die kaltpressgeschweißte Übergangszone zu bilden.

**Figur 22** und **Figur 23** zeigen Beispiele 02h und 02i, die wiederum prismatische Ausnehmungen 07h und 07i aufweisen. An den Endquerschnitten der Ausnehmungen 07h und 07i wird dabei entweder eine quadratförmige Fase 23 oder ein quadratförmiger Radius 24 angebracht.

**Figur 24** zeigt eine Leiterbahn 25, wobei der rechteckförmige Außenumfang der Leiterbahn 25 lediglich beispielhaft zu verstehen ist. In der Leiterbahn 25 ist eine Ausnehmung 26 vorgesehen, in die ein Kontaktstift 03 eingesteckt werden kann. Um für einen festen und dauerhaften Sitz des Kontaktstifts 03 in der Ausnehmung 26 zu sorgen, sind in der Leiterbahn 25 zusätzlich zwei Entlastungsschlitze 27 angebracht, die den Kontaktbereich 28 abschnittsweise umgreifen. Durch die Entlastungsschlitze 27 wird eine elastische Aufweitung des kreisringförmigen Kontaktbereichs 28 im Bereich der Entlastungsschlitze 27 ermöglicht, sodass der Kontaktbereich 28 nach Einpressen des Kontaktstifts 03 elastisch vorgespannt ist und den Innenumfang der Ausnehmung 26 elastisch gegen den Außenumfang des Kontaktstifts 03 presst.

## Patentansprüche

1. Elektrisches Funktionsbauteil (01) mit zumindest einer elektrisch leitenden Leiterbahn (02b) und zumindest einem Kontaktstift (03), wobei an der Leiterbahn (02b) der Kontaktstift (03) angebracht ist, der mit einem funktionskomplementären Kontaktelement, insbesondere in einem Stecker oder einer Fassung, kontaktierbar ist, und wobei zwischen Leiterbahn (02b) und Kontaktstift (03) eine Kontaktzone vorgesehen ist, die die Leiterbahn (02b) und den Kontaktstift (03) elektrisch leitend miteinander verbindet, wobei die Kontaktzone durch Einpressen des Kontaktstifts (03) in eine Ausnehmung (07b) der Leiterbahn (02b) ausgebildet ist, und wobei die elektrisch leitende Kontaktzone in der Art einer ringförmigen, kaltpressgeschweißten Übergangszone (11) ausgebildet ist, wobei das Oberflächenmaterial der Leiterbahn (02b) und/oder das Oberflächenmaterial des Kontaktstifts (03) in der Übergangszone (11) zumindest eine Kaltumformzone (12, 14) aufweist, und wobei an oder in zumindest einer Kaltumformzone (12, 14) zumindest bereichsweise eine Schweißzone (13) vorhanden ist, in der der Kontaktstift (03) und die Leiterbahn (02b) elektrisch leitend stoffschlüssig miteinander verbunden sind,
**dadurch gekennzeichnet,**
**dass** die den Kontaktstift (03) aufnehmende Ausnehmung (07b) einen konusabschnittsförmigen Querschnitt aufweist, wobei sich die Ausnehmung (07b) in Fügerichtung des Kontaktstifts (03) verengt.

2. Elektrisches Funktionsbauteil nach Anspruch 1,
**dadurch gekennzeichnet,**
**dass** die Leiterbahn (02b) von einem Leiterblech (05), insbesondere einem Stanzgitter, gebildet wird.

3. Elektrisches Funktionsbauteil nach Anspruch 1 oder 2,
**dadurch gekennzeichnet,**
**dass** die Leiterbahn (02b) im Bereich der Kontaktzone einen ringförmigen Überstand (08b) aufweist, der eine Materialverdickung in der Leiterbahn (02b) bildet.

4. Elektrisches Funktionsbauteil nach einem der Ansprüche 1 bis 3,
**dadurch gekennzeichnet,**
**dass** der Kontaktstift (03) die Leiterbahn (02b) in einer Ausnehmung (07b) vollständig durchgreift und mit beiden Enden über die Leiterbahn (02b) zumindest ein Stück weit übersteht.

5. Elektrisches Funktionsbauteil nach einem der Ansprüche 1 bis 4,
**dadurch gekennzeichnet,**
**dass** der Kontaktstift (03) an zumindest einem Ende eine Querschnittsverengung, insbesondere eine Fase oder einen Radius an zumindest einem Endquerschnitt oder einen konusabschnittsförmigen Querschnitt, aufweist.

6. Elektrisches Funktionsbauteil nach Anspruch 5,
**dadurch gekennzeichnet,**
**dass** der Kontaktstift an zumindest einer Stirnseite (29) eine Rissfläche aufweist, wobei der Querschnitt des Kontaktstifts an der Stirnseite (29) eingeschnürt ist.

7. Elektrisches Funktionsbauteil nach einem der Ansprüche 1 bis 6,
**dadurch gekennzeichnet,**
**dass** der Kontaktstift (03) einen zumindest bereichsweise kalibrierten Außenumfang (15) aufweist und/oder dass die Ausnehmung (07b) einen zumindest bereichsweise kalibrierten Innenumfang (16) aufweist.

8. Elektrisches Funktionsbauteil nach einem der Ansprüche 1 bis 7,
**dadurch gekennzeichnet,**
**dass** die Leiterbahn (02b) und/oder der Kontaktstift (03) eine metallische Beschichtung aufweist.

9. Elektrisches Funktionsbauteil nach Anspruch 8,
**dadurch gekennzeichnet,**
**dass** der Umformwiderstand des Beschichtungsmaterials geringer ist als der Umformwiderstand des beschichteten Materials.

10. Elektrisches Funktionsbauteil nach einem der Ansprüche 1 bis 9,
**dadurch gekennzeichnet,**
**dass** das Funktionsbauteil (01) in der Art einer Leiterplatte oder eines Steckers oder eines Leuchtmittels ausgebildet ist.

11. Verfahren zur Herstellung eines elektrischen Funktionsbauteils (01) mit folgenden Verfahrensschritten:
a) Herstellung zumindest einer Ausnehmung (07b) mit einem konusabschnittsförmigen Querschnitt in einer elektrisch leitenden Leiterbahn (02b);
b) Zuführen eines Kontaktstifts (03), dessen Außenumfang (15) zumindest abschnittsweise größer als der Innenumfang (16) der konusabschnittsförmigen Ausnehmung (07b) ist, wobei ein Ende des Kontaktstifts (03) an der konusabschnittsförmigen Ausnehmung (07b) angelegt oder eingeführt wird, wobei sich die Ausnehmung (07b) in Fügerichtung des Kontaktstifts (03) verengt.
c) Einpressen des Kontaktstifts (03) in die konusabschnittsförmige Ausnehmung (07b), wobei durch die Querschnittsüberschneidung zwischen Kontaktstift (03) einerseits und der Ausnehmung (07b) in der Leiterbahn (02b) anderseits beim Einpressen eine ringförmige, kaltpressgeschweißte Übergangszone (11) ausgebildet wird, in deren Schweißzone (13) der Kontaktstift (03) und die Leiterbahn (02) stoffschlüssig elektrisch leitend miteinander verbunden sind.

12. Verfahren nach Anspruch 11,
**dadurch gekennzeichnet,**
**dass** im Verfahrensschritt a) ein Leiterblech (05) mit einem Stanzwerkzeug gelocht wird.

13. Verfahren nach Anspruch 12,
**dadurch gekennzeichnet,**
**dass** das gelochte Leiterblech (05) unter Bildung eines ringförmigen Überstands (08b), insbesondere mit einem Dorn, durchgezogen wird.

14. Verfahren nach einem der Ansprüche 11 bis 13, **dadurch gekennzeichnet,**
**dass** zur Herstellung des Kontaktstifts (03) ein endloses Drahtmaterial in Drahtabschnitte, insbesondere mit endseitigen Einschnürungen, gerissen wird, wobei an den Stirnseiten (29) des Kontaktstifts (03) Rissflächen gebildet werden.

## Claims

1. An electrical functional component (01) having at least one electrically conductive conductor strip (02b) and at least one contact pin (03), said contact pin (03) being mounted on the conductor strip (02b) and being able to be contacted with a contact element complementary in function, in particular in a plug or a socket, and a contact zone being provided between the conductor strip (02b) and the contact pin (03), said contact zone electrically connecting the conductor strip (02b) and the contact pin (03) to each other, the contact zone being formed by pressing the contact pin (03) into a recess (07b) of the conductor strip (02b) and the electrically conductive contact zone being formed in the type of an annular cold-pressure-welded transition zone (11), the surface material of the conductor strip (02b) and/or the surface material of the contact pin (03) comprising at least one cold-working area (12, 14) in the transition zone (11), a welding zone (13) being provided at least in sections on or in at least one cold-working zone (12, 14), the contact pin (03) and the conductor strip (02b) being connected to each other in the welding zone (13) by material bonding in an electrically conductive manner,
**characterised in that**
the recess (07b) receiving the contact pin (03) comprises a cone-segment-shaped cross section, the recess (07b) narrowing in the joining direction of the contact pin (03).

2. The electrical functional component according to claim 1,
**characterised in that**
the conductor strip (02b) is formed by a conductive sheet (05), in particular a punched grid.

3. The electrical functional component according to claim 1 or 2,
**characterised in that**
the conductor strip (02b) comprises an annular protrusion (08b) in the area of the contact zone, said protrusion (08b) forming a material thickening in the conductor strip (02b).

4. The electrical functional component according to any one of the claims 1 to 3,
**characterised in that**
the contact pin (03) engages entirely through the conductor strip (02b) in a recess (07b) and at least partially protrudes over the conductor strip (02b) with both ends.

5. The electrical functional component according to any one of the claims 1 to 4,
**characterised in that**
the contact pin (03) comprises a cross-sectional reduction on at least one end, in particular a chamfer or a radius on at least one end cross section or a cone-segment-shaped cross section.

6. The electrical functional component according to claim 5,
**characterised in that**
the contact pin comprises a tear surface on at least one frontal side (29), the cross section of the contact pin being constricted at the frontal side (29).

7. The electrical functional component according to any one of the claims 1 to 6,
**characterised in that**
the contact pin (03) comprises an outer perimeter (15) calibrated at least in sections and/or that the recess (07b) comprises an inner perimeter (16) calibrated at least in sections.

8. The electrical functional component according to any one of the claims 1 to 7,
**characterised in that**
the conductor strip (02b) and/or the contact pin (03) comprise(s) a metallic coating.

9. The electrical functional component according to claim 8,
**characterised in that**
the resistance to deformation of the coating material is less than the resistance to deformation of the coated material.

10. The electrical functional component according to any one of the claims 1 to 9,
**characterised in that**
the functional component (01) is realised in the type of a printed circuit board or a plug or an illuminant.

11. A method for producing an electrical functional component (01), comprising the following method steps:
a) producing at least one recess (07b) having a cone-segment-shaped cross section in an electrically conductive conductor strip (02b);
b) supplying a contact pin (03), whose outer perimeter (15) is larger than the inner perimeter (16) of the cone-segment-shaped recess (07b) at least in sections, an end of the contact pin (03) being disposed at or inserted into the cone-segment-shaped recess (07b), the recess (07b) narrowing in the joining direction of the contact pin (03);
c) pressing the contact pin (03) into the cone-segment-shaped recess (07b), an annular cold-pressure-welded transition zone (11) being formed by the cross-sectional overlap between the contact pin (03) on the one hand and the recess (07b) in the conductor strip (02b) on the other hand while the contact pin (03) is pressed in, said contact pin (03) and said conductor strip (02b) being electrically connected to each other in the welding zone (13) of the transition zone (11) by material bonding.

12. The method according to claim 11,
**characterised in that**
a conductive sheet (05) is hole-punched in method step a) using a punching tool.

13. The method according to claim 12,
**characterised in that**
the hole-punched conductive sheet (05) is pervaded, in particular by means of a mandrel, resulting in the formation of an annular protrusion (08b).

14. The method according to any one of the claims 11 to 13,
**characterised in that**
a continuous wire material is torn into wire sections, in particular having constrictions at their ends, in order to produce the contact pin (03), tear surfaces being formed at the frontal sides (29) of the contact pin (03).

## Revendications

1. Composant (01) fonctionnel électrique comprenant au moins une piste (02b) conductrice et au moins une broche (03) de contact, la broche (03) de contact étant disposée à la piste (02b) conductrice et pouvant être contactée avec un élément de contact complémentaire en fonction, en particulier dans un connecteur mâle ou une douille, et une zone de contact étant prévue entre la piste (02b) conductrice et la broche (03) de contact, la zone de contact reliant la piste (02b) conductrice à la broche (03) de contact de manière électriquement conductrice, la zone de contact étant formée en pressant la broche (03) de contact dans un évidement (07b) de la piste (02b) conductrice, la zone de contact électriquement conductrice étant formée à la façon d'une zone (11) de transition annulaire et soudée par pression à froid, le matériau de surface de la piste (02b) conductrice et/ou le matériau de surface de la broche (03) de contact ayant au moins une zone (12, 14) de travail à froid dans la zone (11) de transition, et une zone (13) de soudage étant présente au moins par sections à ou dans au moins une zone (12, 14) de travail à froid, la broche (03) de contact et la piste (02b) conductrice étant reliées les unes aux autres de manière électriquement conductrice et par liaison de matière dans ladite zone (13) de soudage,
**caractérisé en ce que**
l'évidement (07b) recevant la broche (03) de contact a une coupe transversale en forme de tronçon conique, l'évidement se rétrécissant en direction de joint de la broche (03) de contact.

2. Composant fonctionnel électrique selon la revendication 1,
**caractérisé en ce que**
la piste (02b) conductrice est réalisée par une tôle (05) conductrice, en particulier par une grille de perforation.

3. Composant fonctionnel électrique selon la revendication 1 ou 2,
**caractérisé en ce que**
la piste (02b) conductrice comprend une saillie (08b) annulaire dans la région de la zone de contact, la saillie (08b) formant un renflement de matériau dans la piste (02b) conductrice.

4. Composant fonctionnel électrique selon l'une quelconque des revendications 1 à 3,
**caractérisé en ce que**
la broche (03) de contact s'engage totalement à travers la piste (02b) conductrice dans un évidement (07b) et fait saillie au moins en partie par-dessus la piste (02b) conductrice avec ses deux extrémités.

5. Composant fonctionnel électrique selon l'une quelconque des revendications 1 à 4,
**caractérisé en ce que**
la broche (03) de contact a un rétrécissement de la coupe transversale à au moins une extrémité, en particulier un chanfrein ou un rayon à au moins une coupe transversale d'extrémité ou une coupe transversale en forme de tronçon conique.

6. Composant fonctionnel électrique selon la revendication 5,
**caractérisé en ce que**
la broche (03) de contact a une surface de déchirure à au moins une face (29) frontale, la coupe transversale de la broche de contact étant rétrécie à la face (29) frontale.

7. Composant fonctionnel électrique selon l'une quelconque des revendications 1 à 6,
**caractérisé en ce que**
la broche (03) de contact a une circonférence (15) extérieure qui est calibrée au moins par sections et/ou que l'évidement (07b) a une circonférence (16) intérieure qui est calibrée au moins par sections.

8. Composant fonctionnel électrique selon l'une quelconque des revendications 1 à 7,
**caractérisé en ce que**
la piste (02b) conductrice et/ou la broche (03) de contact comprend/comprennent un revêtement métallique.

9. Composant fonctionnel électrique selon la revendication 8,
**caractérisé en ce que**
la résistance à la déformation du matériau de revêtement est moindre que la résistance à la déformation du matériau revêtu.

10. Composant fonctionnel électrique selon l'une quelconque des revendications 1 à 9,
**caractérisé en ce que**
le composant (01) fonctionnel est réalisé à la façon d'un circuit imprimé ou d'un connecteur mâle ou d'un agent lumineux.

11. Procédé pour la production d'un composant (01) fonctionnel électrique, comprenant les étapes de procédé suivantes :
a) produire au moins un évidement (07b) ayant une coupe transversale en forme de tronçon conique dans une piste (02b) électriquement conductrice ;
b) amener une broche (03) de contact dont la circonférence (15) extérieure est plus grande au moins par sections que la circonférence (16) intérieure de l'évidement (07b) en forme de tronçon conique, une extrémité de la broche (03) de contact étant disposée à ou insérée dans l'évidement (07b) en forme de tronçon conique, l'évidement (07b) se rétrécissant en direction de joint de la broche (03) de contact ;
c) presser la broche (03) de contact dans l'évidement (07b) en forme de tronçon conique, une zone (11) de transition annulaire et soudée par pression à froid étant formée lors du pressage par le chevauchement des coupes transversales entre la broche (03) de contact d'une part et l'évidement (07b) dans la piste (02b) conductrice d'autre part, la broche (03) de contact et la piste (02b) conductrice étant reliées les unes aux autres de manière électriquement conductrice par liaison de matière dans la zone (13) de soudage de ladite zone (11) de transition.

12. Procédé selon la revendication 11,
**caractérisé en ce qu'**
une tôle (05) conductrice est perforée dans l'étape de procédé a) en utilisant un outil de découpage.

13. Procédé selon la revendication 12,
**caractérisé en ce que**
la tôle (05) conductrice perforée est traversée, en particulier par un mandrin, résultant en une saillie (08b) annulaire.

14. Procédé selon l'une quelconque des revendications 11 à 13,
**caractérisé en ce qu'**
un matériau de fil continu est déchiré en sections de fil, en particulier ayant des rétrécissements à leurs extrémités, pour produire la broche (03) de contact, des surfaces de déchirure étant formées aux faces (29) frontales de la broche (03) de contact.
